# EUROPEAN PATENT APPLICATION

(11) **EP 1 158 572 A1**
(43) Date of publication of application: **28.11.2001**
(21) Application number: 01000174.1
(22) Date of filing: 22.05.2001
(51) Int. Cl.: H01L 21/265, H01L 21/8234

(54) **Implantation method for forming an integrated circuit with two sorts of MOSFETs on a substrate**

(30) Priority: 23.05.2000 US 206576
(71) Applicant: Texas Instruments Incorporated, Dallas, Texas 75251 (US)
(72) Inventor: Kim, Youngmin, Allen Texas 75013 (US); Jacobs, Jarvis B., Richardson Texas 75081 (US)
(74) Representative: Holt, Michael

(57) **Abstract**

A method of fabricating an integrated circuit having at least two types of transistors (300,301) with different doping profiles. The gate electrodes (302) of the first type (300) are aligned in a first direction and the gate electrodes (310) of the second type (301) are aligned in a second direction at an angle beta from the first direction. An angled implant is performed at wafer rotation angles of 0 and 180 to form, for example, pocket regions (305,311). Due to the orientation of the gate electrodes, region (305) extends further under the gate electrode (302) than region (311) extends under gate electrode (310).

## Description

### FIELD OF THE INVENTION

The instant invention pertains to semiconductor device fabrication and processing and more specifically to a method of implanting dopant into regions of different device types to achieve different device performance with a single mask.

### BACKGROUND OF THE INVENTION

Implantation of dopants into the semiconductor substrate (or epitaxial silicon layer which overlies the semiconductor substrate) is important in semiconductor device fabrication. Many different implantation steps need to be performed so as to: dope the polycrystalline silicon ("poly" or "polysilicon") gate structure, form drain extensions, form pockets, form source and drain regions, form isolation structures, and to increase or decrease the conductivity of semiconductor structures. A problem with all of these implantation steps is that they may require separate masks so as to block the implantation of dopants from one region while exposing others to the implantation of dopants. Formation of these masks is very expensive and can be quite difficult to implement due to the ever-shrinking feature sizes and the difficulties associated with present limitations on photolithography. Some relief from these problems can be achieved by using existing structures to define the regions in which dopants are implanted. However, this self-alignment methodology cannot solve all of the problems related to precisely implanting dopants into these semiconductor structures.

Typically, dopants are implanted into the semiconductor structure normal to the semiconductor wafer (hereinafter referred to as an angle, phi, which would be equal to zero degrees if it were normal to the wafer). However, implanting normal to the wafer can be problematic. One problem associated with implanting normal to the wafer is channeling through silicon crystalline, causing non-uniformly doped region over wafer. In an effort to alleviate this problem, semiconductor device manufacturers have started to implant dopants at an angle from the normal to the wafer. However, this, too, can be problematic. For example, one problem is the shadowing effect due to poly or resist. In order to properly implant into the areas that are to be doped, semiconductor device manufacturers have altered their implantation methodology so as to implant the dopants with angle phi being greater than zero degrees. In order to reduce the shadowing from existing structures, a portion of the dopants are implanted and then the wafer is rotated (within the same plane that the wafer is situated) about an angle, theta. If the wafer were rotated four times (theta would be at 0, 90, 180 and 270 degrees) then a quarter of the dopants would be implanted at each of these values of theta. The same proportionality would be used for any incremental rotation of the wafer.

As indicated above, the progression of source/drain technology has produced a very complex drain/source structure for the smallest channel length, core transistor, for digital applications. However, the current roadmap of this technology requires the integration of input/output transistors, and new specialized transistors, e.g., analog transistors, which must also pass performance specifications, e.g., drive current and off-current, and reliability constraints, e.g., CHC (channel hot carrier) and ESD (electrostatic discharge). With a complex drain/source technology, it has become increasingly difficult to meet these goals with one source/drain design.

In the past, the traditional approach of solving the multi-constraints of several transistor requirements has been to create each transistor uniquely with device specific lithographic steps, but this increases cost. Hence, there is a need for a methodology that will esult in one structure being implanted with a dopant while another structure remains free of that dopant without having to use additional masking.

### SUMMARY OF THE INVENTION

The invention is a method of fabricating an integrated circuit having at least two types of transistors with different doping profiles. The gate electrodes of the first type are aligned in a first direction and the gate electrodes of the second type are aligned in a second direction at an angle beta from the first direction. An angled implant is performed at wafer rotation angles (e.g., 0° and 180°) to form a first area and a second area. The first area extends under the gate electrodes of the first transistor type more than the second area extends under the gate electrode of the second transistor type due to the orientation of the gate electrodes.

An advantage of the invention is providing a method of forming MOSFETs having different doping profiles without additional masking levels.

### BRIEF DESCRIPTION OF THE DRAWINGS

Preferred and exemplary embodiments of the present invention will now be described in greater detail, by way of example only, and with reference to the figures of the accompanying drawings in which:
FIGURE 1 is a top view of a partially fabricated device of the prior art.
FIGUREs 2a-2c are cross-sectional views of partially fabricated devices of the prior art as is depicted in FIGURE 1.
FIGURE 3 is a top view of a partially fabricated device that is fabricated using the method of an embodiment of the instant invention.
FIGURE 4a is a cross-sectional view of a partially fabricated device that is fabricated using the method of an embodiment of the instant invention.
FIGURE 4b is a cross-sectional view of a partially fabricated device that is fabricated using the method of an embodiment of the instant invention.
FIGURE 5 is a graph of doping concentration versus lateral distance indicating the advantage of the invention for an angled implant.

Similar reference numerals are used throughout the figures to designate like or equivalent features. The figures are not drawn to scale. They are merely provided to illustrate the affect of the method of the instant invention.

### DETAILED DESCRIPTION OF THE DRAWINGS

As CMOS technology advances, there have been attempts to integrate various circuits, such as analog and RF applications, into a CMOS logic chip to take advantage of the cost and the compactness offered by the technology. The attempts, however, require additional MOSFET optimization to satisfy different aspects of the various circuits. For example, most of analog circuits require high early voltage (Va) transistor to offer high analog circuit performance, which has not been considered when a MOSFET is designed for digital applications. Often those aspects of a transistor design conflict each other and a single design solution may not exist to meet all the requirements. For those cases, additional patterning step is necessary to integrate the circuits onto a same chip, leading to higher cost.

In this disclosure, a fabrication method is invented which is able to integrate two different types source/drain (S/D) with a single mask. Use of the method can eliminate an existing masking step that has been used to integrate two different types MOSFETs on a chip and thus lower the fabrication cost. The invention includes a scheme in which by varying the alignment of MOSFET gate to the direction of tilted implant, dopant underneath gate can be tailored and makes different type MOSFET without masking step.

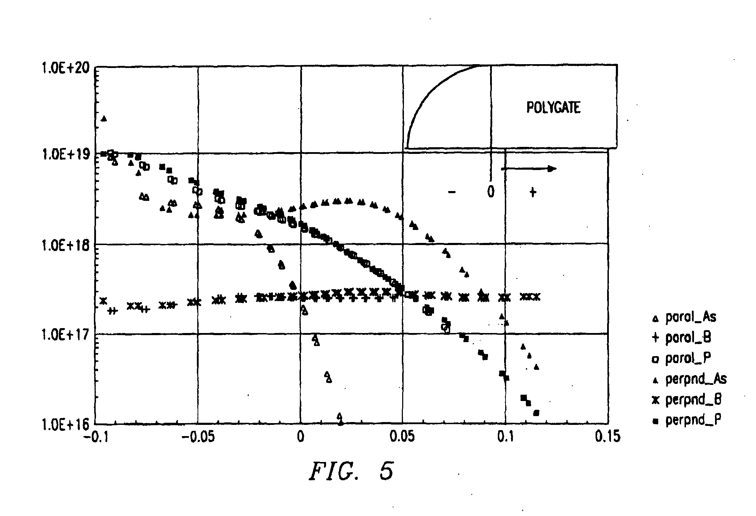

Figure 5 illustrates two cases of a set of MOSFET design that are simulated using a process simulation tool. The x-axis is the lateral distance from the gate edge to the middle of the channel. The yaxis is the doping concentration. In the example of FIGURE 5, only the arsenic implant is angled. Phosphorous is implanted at 3E13cm⁻² @ 40keV and arsenic at 2.5E13cm⁻² @110 keV with a 25º tilt. Two-way rotations (e.g., 0° and 180°) were used. This allows the arsenic implant to be placed ahead of the phosphorous implant only in a transistor that has a gate aligned perpendicular to the arsenic implant. In a gate aligned parallel to the arsenic implant, the phosphorous is ahead of the arsenic. By changing the arsenic position relative to the phosphorous, the transistors can meet both ESD and CHC specs.

In essence, the methodology of the instant invention involves orienting devices with different electrical characteristics (such as breakdown voltage, V_{bd}, or Early Voltage, Vₐ) at different angles, beta, from each other so that angled implants affect these devices differently. For example, devices that are oriented orthogonal to each other will have different source/drain configuration due to the different angled implants used to form these regions. The embodiment of the instant invention as illustrated in the instant figures can be altered by one of ordinary skill in the art, based on the teachings herewith, to utilize the instant invention while obtaining different devices types. For example, the instant invention is illustrated in the figures as an NMOS device, however the instant invention can be implemented as PMOS devices, analog devices, power devices, low voltage devices, RF devices or an mixture of the above where the electrical characteristics of the devices need to be different than those of another device and wherein this difference can be achieved using different implant regions.

While the figures specifically use certain structures, one of ordinary skill in the art should be able to utilize different conventional structures in place of some of the ones illustrated. For example, while shallow trench isolation structures are illustrated, any type of conventional isolation structure can be used. More specifically, field oxidation or implant regions may be used to isolate devices from each other. In addition, the devices illustrated in the figures are partially fabricated devices that are provided for illustrative purpose. Therefore, some of the process steps may be altered or may not be shown in the figures. For example, sidewall insulation regions are preferably formed on the sidewalls of the gate structures but these are not illustrated in the instant figures.

The semiconductor structure 320 may be a single-crystalline silicon substrate or an epitaxial (or even polysilicon) silicon layer formed on a single-crystal silicon or glass substrate. Gate structures 302 and 310 are formed by depositing or growing a gate insulating layer (preferably comprised of an oxide, a nitride, an oxynitride, a high dielectric constant material, a silicate, a stack of any of the above, or any combination thereof), forming a gate conductor (preferably comprised of polycrystalline silicon, a metal, or other conductor) on the gate insulating layer, patterning and etching the gate conductor and gate insulating layer so as to form the gate structure, and, if necessary, doping the gate conductor.

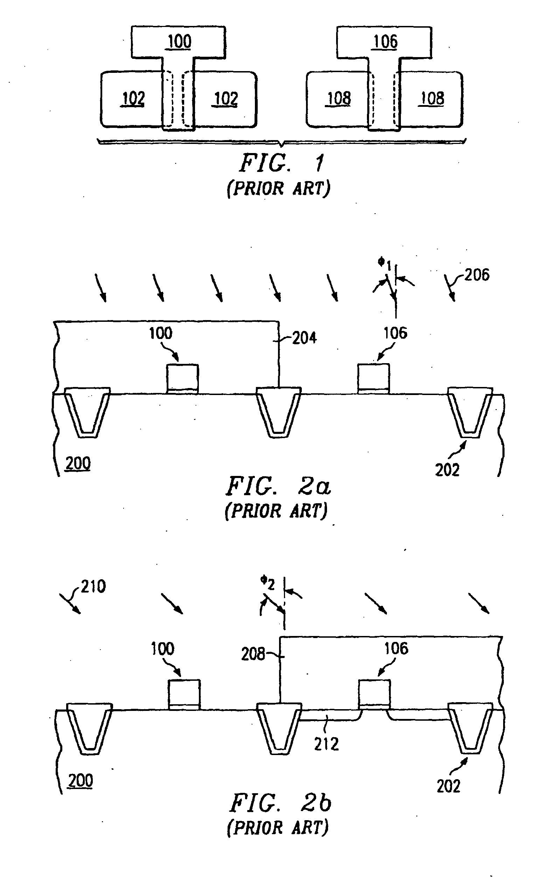

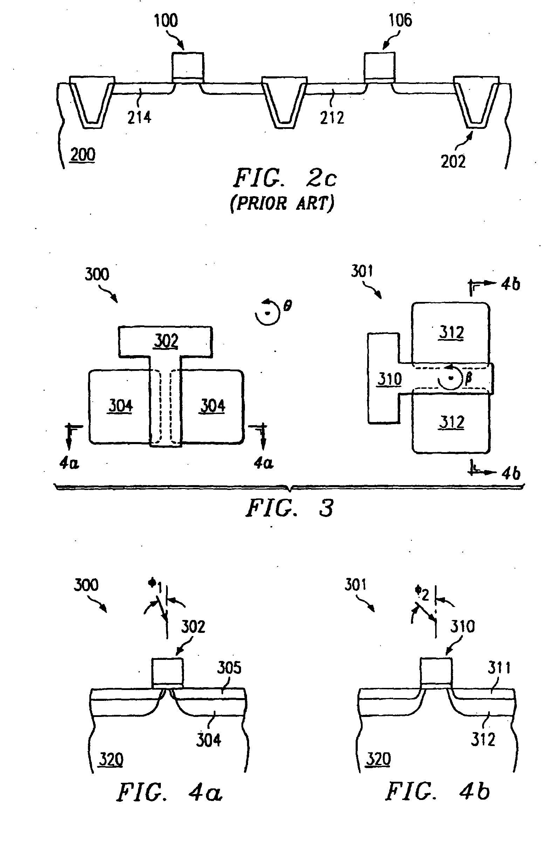

Referring to FIGUREs 1 and 2a-2c, gate structures 100 and 106 and source/drain regions 102 and 108, respectively, are used to represent transistors of different device types. For example, one transistor may be a low-power, high-speed logic transistor while the other transistor is a higher-power device (such as an I/O device or a power device). Alternatively, one device may be an analog device and the other may be a logic device. Using conventional methodology, these different devices would be oriented, with respect to each other, so as to minimize the amount of space used to lay out the devices. In most cases, these devices will be laid out so that the two devices are oriented, with respect to each other, such that they are aligned (hence no rotational difference between them - beta equals zero). This type of configuration is shown in FIGURE 1. In order to distinguish these devices with respect to their implanted regions, a fairly complex methodology must be used (as is illustrated in FIGUREs 2a-2c). Using this methodology, a masking layer 204 must be used to block the implant used to form the extended drain regions and the source/drain implants from entering into one device while it is being introduced to the other device. The implant angle, phi, may be either fairly large or small. If the angle is small, then little implantation under the gate will occur. If the angle is fairly large, then more of the dopants will be implanted under the gate structure. Half of the dopants for this implant will be implanted with theta equal to zero and the other half will be implanted after the wafer is rotated 180 degrees (theta equal to 180 degrees). After this implantation step, mask 204 is removed and another mask, mask 208 is used to mask off the device that was implanted into in FIGURE 2a. With one device type exposed, a second implant step is performed. This implant 210 will be accomplished with either phi being lesser or greater than the phi used in the first implant. If phi is greater than that of the first implant, then the encroachment of the drain extension and/or source/drain regions will be greater. This greater encroachment under the gate structure is illustrated in FIGURE 2c as region 214 (as opposed to the shallower implant 206, which yields less encroachment as is shown by regions 212).

A problem with this conventional technique is that at least two separate masks are needed to implant dopants into these devices. However, one advantage of this methodology is that the devices can be laid out at any arbitrary orientation to one another so as to minimize the area required to fabricate these devices and their interconnections.

Referring to the instant invention in connection with FIGURES 3 and 4a-4b, in essence the instant invention involves a method of implanting dopant into a silicon structure 320 to fabricate different device types. This difference in device types is achieved, at least in part, due to the different orientation of the devices with respect to one another. Preferably, one type of devices is rotated so that it is oriented either 90 or 270 degrees from the other device type(s). This is illustrated in FIGURE 3, where device 301 is rotated an angle, beta, which is around 90 degrees when compared to device 300. Angle theta represents the rotation of the entire wafer. This is important during these angled implant steps so that dopants are not shadowed in areas where they are desired by existing structures. Preferably, where beta is 90 or 270 degrees and the implant is angled, where phi is between (10 and 70) degrees (preferably around 20 to 45 degrees - most preferably around 25 to 30 degrees) off of the normal of the wafer, half of the dopants are implanted with theta equal to 0 degrees and the other half is implanted with theta equal to 180 degrees. The zero degree point for theta should be chosen so that the implant is directed for maximum encroachment under the gate structure for the device need the maximum encroachment under the gate (to lower the breakdown voltage, for example). In FIGURE 3, theta would be equal to the zero degree point where the maximum amount of dopants are implanted under gate structure 302 in the area of source/drain regions 304. In addition, this zero degree point for theta will also be the point where the least amount of encroachment of implanted dopants will occur for the other device type if it is oriented where beta is either 90 or 270 degrees. Theta and beta can be manipulated so as to tailor the amount of implant encroachment under the gate structures. The embodiment of FIGUREs 3 and 4a-4b is the maximal/minimal case.

In one embodiment of the instant invention, device 301 would preferably be a device used in the analog circuitry and device 300 would be used for the core of a digital signal processor (DSP) or any other high-speed, low-power logic device. Pocket implant 305 (which is preferably doped with arsenic or boron) is preferable for the bgic device 300 but is not beneficial for analog device 301. Hence, this implant is formed using the methodology of the instant invention thereby pulling back pocket 311 from gate structure 310. However, the pocket implant 305 extends well under logic gate 302 even though these two pocket implant regions are formed simultaneously. The implanted regions of FIGURES 4a and 4b represent the implanted regions after the devices have been subjected to an anneal step. However, these could represent the as-implanted case if need be.

The implants may be utilized to dope gate structures 302 and 310, form source and drain regions, form drain extensions, form pocket regions, to selectively dope the channel region, to form any other implanted structures, or to accomplish any combination of the above. Preferably, the implants are comprised of boron, phosphorous, arsenic, germanium, silicon, gallium, nitrogen, oxygen, or any combination of the above. The implantation angle, phi, is preferably around 15 to 60 degrees (more preferably around 20 to 50 degrees, even more preferably around 30 to 45 degrees, and most preferably around 40 to 45 degrees).

Although specific embodiments of the present invention are herein described, they are not to be construed as limiting the scope of the invention. Many embodiments of the present invention, such as making ESD transistor different from I/O transistor, will become apparent to those skilled in the art in light of methodology of the specification.

## Claims

1. A method of fabricating an integrated circuit comprising:
forming a first plurality of gate electrodes over a semiconductor body aligned in a first direction;
forming a second plurality of gate electrodes over the semiconductor body aligned in a second direction, the second direction at a non-zero angle beta from the first direction; and
performing an angled implant at wafer rotation angles so as to implant a first area of the semiconductor body adjacent the first plurality of gate electrodes and a second area of the semiconductor body adjacent the second plurality of gate electrodes, wherein said first area extends under said first plurality of gate electrodes more than said second area extends under said second plurality of gate electrodes.

2. The method of claim 1, wherein said angle beta is approximately 90 degrees.

3. The method of claim 1, wherein said angle beta is approximately 270 degrees.

4. The method of claim 1, wherein said wafer rotation angles comprise a first angle of 0 degrees and a second angle of 180 degrees.

5. The method of claim 1, wherein said angled implant is performed at an angle phi between 10 and 70 degrees off normal.

6. The method of claim 1, wherein said angled implant is performed at an angle phi between 25 and 30 degrees off normal.

7. The method of any preceding claim, wherein said first plurality of gate electrodes form core transistors and said second plurality of gate electrodes form analog transistors.

8. A method of fabricating an integrated circuit having a first transistor type and a second transistors type, which method comprising:
forming a first plurality of gate electrodes of said first transistor type over a semiconductor body aligned in a first direction;
forming a second plurality of gate electrodes of said second transistor type over the semiconductor body aligned in a second direction, the second direction at a non-zero angle beta from the first direction;
forming a masking layer over the semiconductor body;
performing an angled implant of a first dopant at wafer rotation angles of 0 degrees and 180 degrees using the masking layer to implant a first area of the semiconductor body adjacent the first plurality of gate electrodes and a second area of the semiconductor body adjacent the second plurality of gate electrodes, wherein said first area extends under said first plurality of gate electrodes more than said second area extends under the second plurality of gate electrodes and wherein 0 degrees is defined as the angle for maximum encroachment under the first plurality of gate electrodes.

9. The method of claim 8, wherein said angle beta is approximately 90 degrees.

10. The method of claim 8, wherein said angle beta is approximately 270 degrees.

11. The method of claim 8, wherein said angled implant is performed at an angle phi between 10 and 70 degrees off normal.

12. The method of claim 8, wherein said angled implant is performed at an angle phi between 25 and 30 degrees off normal.

13. The method of any of claims 8 to 12, further comprising the step of:
implanting a second dopant at normal angle to form a first implanted region adjacent the first plurality of gate electrodes and a second implanted region adjacent the second plurality of gate electrodes wherein the first area extends under the first plurality of gate electrodes more than the first implanted region and the second implanted region extends under the second plurality of gate electrode more than the second area.
